# EUROPEAN PATENT APPLICATION

(11) **EP 4 521 590 A1**
(43) Date of publication of application: **12.03.2025**
(21) Application number: 23921487.7
(22) Date of filing: 30.11.2023
(51) Int. Cl.: H02J 7/00, G01R 31/367, G01R 31/392, G01R 31/382, G01R 31/385

(54) **APPARATUS AND METHOD FOR DIAGNOSING STATE OF BATTERY**

(30) Priority: 10.02.2023 KR 20230017802
(71) Applicant: LG Energy Solution, Ltd., Seoul 07335 (KR)
(72) Inventor: KANG, Juyoung, Daejeon 3412 (KR); PARK, Heungil, Daejeon 3412 (KR); SEO, Jungoh, Daejeon 3412 (KR); LEE, Dajin, Daejeon 3412 (KR); CHO, Inhwan, Daejeon 3412 (KR)
(74) Representative: Goddar, Heinz J.
(86) International application number: PCT/KR2023/019586
(87) International publication number: WO 2024/167114

(57) **Abstract**

A battery status diagnosing apparatus and method according to the embodiments and experimental examples of the present invention may monitor a charge voltage and charge time of a battery and diagnose abnormal status of the battery which occurs as preliminary signs before ignition of the battery, thereby ensuring safe battery use.

## Description

This application claims priority to and the benefit of Korean Patent Application No.10-2023-0017802 filed in the Korean Intellectual Property Office on February 10, 2023 the entire contents of which are incorporated herein by reference.

### [Technical Field]

The present invention relates to an apparatus and method for diagnosing battery state, and more particularly, to an apparatus and method for diagnosing abnormal status of a battery state by monitoring a charge voltage and charge time in charge cycles of a battery.

### [Background Art]

As depletion of fossil fuels proceeds and interest in environmental pollution increases, a demand for secondary batteries as an eco-friendly alternative energy source is rapidly increasing. Among various alternative energy sources, demand for rechargeable lithium secondary batteries is rapidly increasing.

Lithium secondary batteries are being applied to various industrial fields from mobile application devices to vehicles, robots and energy storage devices, as a response to today's environmental regulations and high oil price issues. However, lithium secondary batteries have a risk of ignition or explosion when an internal or external defect occurs, and thus, it is important to diagnose the condition of the battery in real time.

Accordingly, voltage and temperature used to be monitored to diagnose an abnormal state of the battery in the past.

However, the conventional battery condition diagnosing method has the disadvantage that measurement values are prone to change due to surrounding environmental factors.

### [Detailed Description of the Invention]

### [Technical Problem]

To obviate one or more problems of the related art, embodiments of the present disclosure provide an apparatus for diagnosing battery state.

To obviate one or more problems of the related art, embodiments of the present disclosure also provide a method for diagnosing battery state.

### [Technical Solution]

In order to achieve the objective of the present disclosure, a battery status diagnosing apparatus may include at least one processor; and a memory configured to store at least one instruction executed by the at least one processor, and the at least one instruction may include an instruction to monitor whether an abnormality in voltage measurement values occurs in a specific cycle among a plurality of charge cycles of the battery; an instruction to check charge time of the battery in the next cycle that proceeds after the specific cycle in which the abnormality occurs; and an instruction to diagnose an abnormal status of the battery based on the charge time of the battery in the next cycle.

Here, the charge time may include a first charge time which is the duration it takes to charge the battery using a constant current (CC) charging method; and a second charge time which is the duration it takes to charge the battery using a constant voltage (CV) charging method.

Meanwhile, the instruction to diagnose an abnormal status of the battery may include an instruction to diagnose an abnormal status of the battery by comparing charge time of the specific cycle in which the abnormality occurs with the charge time of the next cycle.

In more detail, the instruction to diagnose an abnormal status of the battery may include an instruction to determine that an abnormality has occurred in the battery in the instance that the constant current (CC) charge time of the next cycle compared to that of the specific cycle increases by equal to or greater than a predefined first threshold or in the instance that the constant voltage (CV) charge time of the next cycle compared to that of the specific cycle decreases by equal to or greater than a predefined second threshold.

In addition, the instruction to diagnose an abnormal status of the battery may include an instruction to determine that an abnormality has occurred in the battery in the instance that the constant current (CC) charge time of the next cycle compared to that of the specific cycle increases by equal to or greater than a predefined first threshold and that the constant voltage (CV) charge time of the next cycle compared to that of the specific cycle decreases by equal to or greater than a predefined second threshold.

Meanwhile, the instruction to monitor whether an abnormality in voltage measurement values occurs in a specific cycle may include an instruction to obtain a plurality of open circuit voltage (OCV) measurement values measured for each charge cycle; an instruction to monitor at least one OCV measurement value, among the plurality of OCV measurement values, that has a change amount greater than a predefined threshold compared to the OCV measurement value in the previous cycle; and an instruction to determine the charge cycle in which at least one OCV measurement value with the change amount greater than a predefined threshold is detected as the specific cycle in which the abnormality occurs.

In addition, the abnormal status of the battery may include a status in which the battery is at risk of ignition or a status in which venting of the battery occurs.

Furthermore, the at least one instruction may further include an instruction to count the number of times the abnormal state of the battery has been diagnosed; and an instruction to output an alarm when the counted number of abnormal status diagnosis is equal to or greater than a predefined threshold value.

According to another embodiment of the present disclosure, a method for diagnosing battery status by a battery status diagnosis apparatus may include monitoring whether an abnormality in voltage measurement values occurs in a specific cycle among a plurality of charge cycles of the battery; checking charge time of the battery in the next cycle that proceeds after the specific cycle in which the abnormality occurs; and diagnosing an abnormal status of the battery based on the charge time of the battery in the next cycle.

Here, the charge time may include a first charge time which is the duration it takes to charge the battery using a constant current (CC) charging method; and a second charge time which is the duration it takes to charge the battery using a constant voltage (CV) charging method.

Meanwhile, the diagnosing the abnormal status of the battery may include diagnosing an abnormal status of the battery by comparing charge time of the specific cycle in which the abnormality occurs with the charge time of the next cycle.

In more detail, the diagnosing the abnormal status of the battery may include determining that an abnormality has occurred in the battery, in the instance that the constant current (CC) charge time of the next cycle compared to that of the specific cycle increases by equal to or greater than a predefined first threshold, or in the instance that the constant voltage (CV) charge time of the next cycle compared to that of the specific cycle decreases by equal to or greater than a predefined second threshold.

In addition, the diagnosing the abnormal status of the battery may include determining that an abnormality has occurred in the battery in the instance that the constant current (CC) charge time of the next cycle compared to that of the specific cycle increases by equal to or greater than a predefined first threshold, and that the constant voltage (CV) charge time of the next cycle compared to that of the specific cycle decreases by equal to or greater than a predefined second threshold.

Meanwhile, the monitoring whether an abnormality in voltage measurement values occurs in a specific cycle may include obtaining a plurality of open circuit voltage (OCV) measurement values measured for each charge cycle; monitoring at least one OCV measurement value, among the plurality of OCV measurement values, that has a change amount greater than a predefined threshold compared to the OCV measurement value in the previous cycle; and determining the charge cycle in which at least one OCV measurement value with the change amount greater than a predefined threshold is detected as the specific cycle in which the abnormality occurs.

In addition, the abnormal status of the battery may include a status in which the battery is at risk of ignition or a status in which venting of the battery occurs.

The method may further include counting the number of times the abnormal state of the battery has been diagnosed; and outputting an alarm when the counted number of abnormal status diagnosis is greater than or equal to a predefined threshold value.

### [Advantageous Effects]

The battery status diagnosing apparatus and method according to the embodiments and experimental examples of the present invention can diagnose a damage to a battery due to external shock, thereby providing improved safety.

### [Brief Description of theDrawings]

FIG.1 is a block diagram of a battery system to which embodiments of the present invention may be applied.
FIG. 2 is a block diagram of a battery status diagnosing apparatus according to embodiments of the present invention.
FIG. 3 is a flowchart for explaining a method for diagnosing a battery condition according to embodiments of the present invention.
FIG. 4 is a graph showing a change in the magnitude of the charge voltage over time for each battery charge cycle according to embodiments of the present invention.
FIG. 5 is a graph showing OCV values measured for each charge cycle of the battery according to an experimental example of the present invention.
FIG. 6 is a table summarizing the OCV values measured for each charge cycle of the battery according to FIG. 5 which is an experimental example of the present invention.
FIG. 7 is a graph showing a first charge time for each battery charge cycle in the battery status diagnosing method according to an experimental example of the present invention.
FIG. 8 is a graph showing the second charge time for each battery charge cycle in the battery status diagnosing method according to another experimental example of the present invention.
FIG. 9 is a graph showing size change of OCV according to charge time for each charge cycle of the battery according to an experimental example of the present invention.

1000: battery status diagnosing apparatus
100: memory
200: processor
300: transceiver
400: input interface
500: output interface
600: storage device
700: bus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

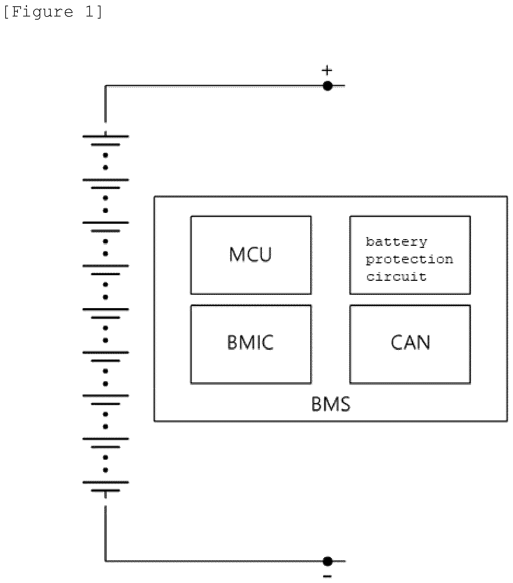

FIG.1 is a block diagram of a battery system to which embodiments of the present invention may be applied.

Referring to FIG. 1, a battery pack or battery module may include a plurality of battery cells connected in series. The battery pack or module may be connected to a load through a positive terminal and a negative terminal to perform charging or discharging. The most commonly used battery cell is a lithium-ion (Li-Ion) battery cell.

A battery management system (BMS) 100 may be connected to a battery module or battery pack.

The battery management system may monitor a current, a voltage and a temperature of each battery cell or module to be managed, calculate state of charge (SOC) of the battery based on monitoring results to control charging and discharging. Here, the State of Charge (SOC) refers to a current state of charge of a battery, represented in percent points [%], and the State of Health (SOH) may be a current condition of a battery compared to its ideal conditions, represented in percent points [%].

The BMS may monitor battery cells, read cell voltages, and transmit them to other systems connected to the battery.

Furthermore, the battery management system monitors at least one electrical component constituting the battery system and passes their status data on to other systems. For this, the BMS includes a communication module for communicating with other systems in a device including the battery system.

The communication module of the BMS can communicate with other systems in the device using CAN (Controller Area Network). Here, components, modules or systems in the BMS are connected to each other through a CAN bus. Accordingly, the battery management system (BMS) may use CAN communication to remotely transmit status data obtained through monitoring of the battery pack or module and at least one electrical component constituting the battery management system (BMS) to other systems.

Furthermore, the battery management system (BMS) may equally balance charges of the battery cells in order to extend the life of the battery system.

The BMS 100 may include various components such as a fuse, a current sensing element, a thermistor, a switch, and a balancer to perform such operations. In most cases, a micro controller unit (MCU) or a battery monitoring integrated chip (BMIC) for interworking and controlling these components is additionally included in the BMS.

Here, the BMIC may be located inside the battery management system (BMS) and may be an IC-type component that measures information such as voltage, temperature, and current of a battery cell/module. According to an embodiment, a battery management system (BMS) may be applied to an automobile.

Meanwhile, generally, a battery management system (BMS) may be connected with a battery protection device which blocks the charging and discharging circuit when a battery abnormality occurs. In other words, a general battery protection circuit blocks the charging and discharging circuit when an abnormality occurs in any one battery cell or module so as to limit the use of the battery.

The battery status diagnosing apparatus according to embodiments of the present invention may be implemented by being included in a battery management system (BMS).

Hereinafter, preferred embodiments according to the present invention will be described in more detail with reference to the attached drawings.

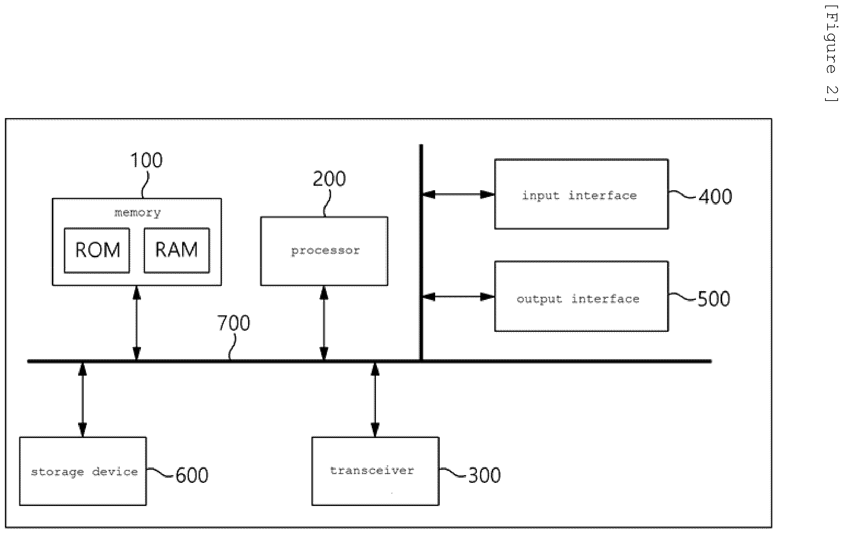

FIG. 2 is a block diagram of a battery status diagnosing apparatus according to embodiments of the present invention.

The battery status diagnosing apparatus 1000 may be a device that pre-diagnoses an abnormal status of the battery in order to prevent battery ignition. In other words, the battery status diagnosing apparatus 1000 may be a device that detects battery abnormalities that occur as preliminary signs before ignition occurs due to thermal runaway of the battery. For example, the abnormal phenomenon may be a gas vent phenomenon.

According to embodiments, the battery status diagnosing apparatus 1000 may monitor charge voltage values obtained in each cycle and may obtain information on a specific cycle in which an abnormality in the charge voltage values has occurred. Thereafter, the battery status diagnosing apparatus 1000 may monitor the charge time in the next cycle after the specific cycle in which the abnormality occurred and may determine whether an abnormality has occurred in the battery or not.

In more detail as to each component of the battery status diagnosing apparatus 1000 according to embodiments of the present invention referring to FIG. 2, the battery status diagnosing apparatus 1000 may include a memory 100, a processor 200, a transceiver 300, an input interface 400, an output interface 500, and a storage device 600.

According to embodiments, respective components 100, 200, 300, 400, 500, 600 included in the battery status diagnosing apparatus 1000 may be connected by a bus 700 to communicate with each other.

The memory 100 and the storage device 600 among the components 100, 200, 300, 400, 500, 600 may include at least one of a volatile storage medium and a non-volatile storage medium. For example, the memory 100 and the storage device 600may include at least one of read only memory (ROM) and random access memory (RAM).

Among them, the memory 100 may include at least one instruction executed by the processor 200.

According to embodiments, the at least one instruction may include an instruction to monitor whether an abnormality in voltage measurement values occurs in a specific cycle among a plurality of charge cycles of the battery; an instruction to check charge time of the battery in the next cycle that proceeds after the specific cycle in which the abnormality occurs; and an instruction to diagnose an abnormal status of the battery based on the charge time of the battery in the next cycle.

Here, the charge time may include a first charge time which is the duration it takes to charge the battery using a constant current (CC) charging method; and a second charge time which is the duration it takes to charge the battery using a constant voltage (CV) charging method.

Meanwhile, the instruction to diagnose an abnormal status of the battery may include an instruction to diagnose an abnormal status of the battery by comparing charge time of the specific cycle in which the abnormality occurs with the charge time of the next cycle.

In more detail, the instruction to diagnose an abnormal status of the battery may include an instruction to determine that an abnormality has occurred in the battery in the instance that the constant current (CC) charge time of the next cycle compared to that of the specific cycle increases by equal to or greater than a predefined first threshold or in the instance that the constant voltage (CV) charge time of the next cycle compared to that of the specific cycle decreases by equal to or greater than a predefined second threshold.

In addition, the instruction to diagnose an abnormal status of the battery may include an instruction to determine that an abnormality has occurred in the battery in the instance that the constant current (CC) charge time of the next cycle compared to that of the specific cycle increases by equal to or greater than a predefined first threshold and that the constant voltage (CV) charge time of the next cycle compared to that of the specific cycle decreases by equal to or greater than a predefined second threshold.

Meanwhile, the instruction to monitor whether an abnormality in voltage measurement values occurs in a specific cycle may include an instruction to obtain a plurality of open circuit voltage (OCV) measurement values measured for each charge cycle; an instruction to monitor at least one OCV measurement value, among the plurality of OCV measurement values, that has a change amount greater than a predefined threshold compared to the OCV measurement value in the previous cycle; and an instruction to determine the charge cycle in which at least one OCV measurement value with the change amount greater than a predefined threshold is detected as the specific cycle in which the abnormality occurs.

In addition, the abnormal status of the battery may include a status in which the battery is at risk of ignition or a status in which venting of the battery occurs.

Furthermore, the at least one instruction may further include an instruction to count the number of times the abnormal state of the battery has been diagnosed; and an instruction to output an alarm when the counted number of abnormal status diagnosis is equal to or greater than a predefined threshold value.

Meanwhile, the processor 200 may mean a central processing unit (CPU), a graphics processing unit (GPU), or a dedicated processor on which methods according to embodiments of the present invention are performed.

The processor 200 may execute at least one program command stored in the memory 100 as described above.

The battery status diagnosing apparatus according to embodiments of the present invention has been described above. Hereinafter, a battery status diagnosing method performed by process operations of the battery status diagnosing apparatus will be described.

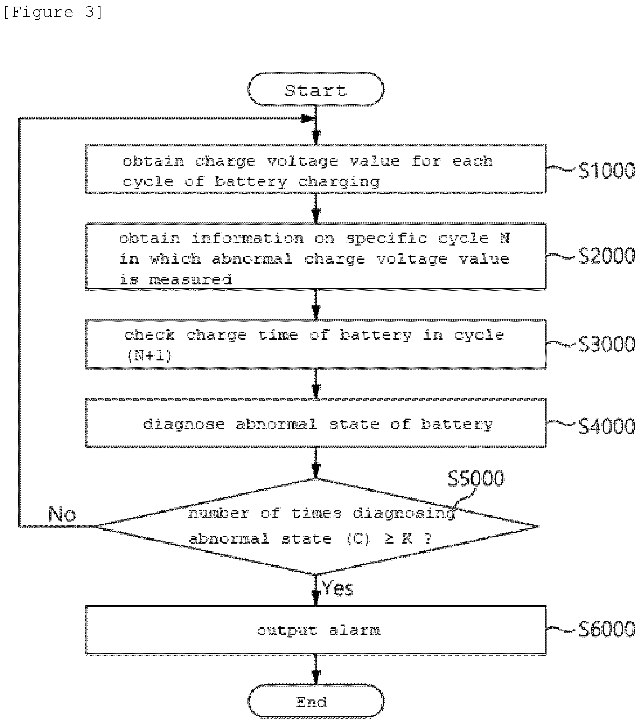

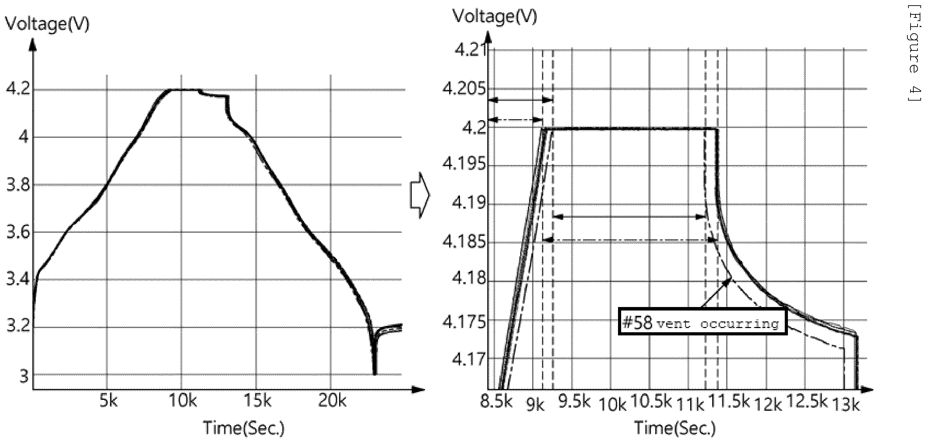

FIG. 3 is a flowchart for explaining a method for diagnosing a battery condition according to embodiments of the present invention and FIG. 4 is a graph showing a change in the magnitude of the charge voltage over time for each battery charge cycle according to embodiments of the present invention.

Referring to FIGS. 3 and 4, the battery status diagnosing apparatus 1000 may obtain a charge voltage value for each cycle of battery charging (S1000). According to an embodiment, the charge voltage value may be data measured for each charge cycle by the battery status diagnosing apparatus 1000 or may be data received from an external device.

Thereafter, the battery status diagnosing apparatus 1000 may monitor whether an abnormality occurs in the measured charge voltage values obtained for each cycle and obtain information on the specific cycle in which the abnormal charge voltage value is measured (S2000).

According to an embodiment, the battery status diagnosing apparatus 1000 may determine that an abnormality has occurred in the charge voltage value in the instance that a charge voltage value in a certain cycle has a change amount equal to or greater than a predefined threshold value compared to the charge voltage value in the previous cycle among the plurality of charge voltage values measured for each cycle. Thereafter, the battery status diagnosing apparatus 1000 may obtain information on the specific cycle in which the corresponding charge voltage value was measured. For example, the charge voltage value may be a charge Open Circuit Voltage (OCV) value. Here, the charge OCV may be a voltage measured when no current flows to the battery in a charged state.

In other words, the battery status diagnosing apparatus 1000 may determine that an abnormality has occurred in a corresponding OCV value in the instance that the corresponding OCV value in a certain cycle has a change amount equal to or greater than a predefined threshold value compared to the OCV value in the previous cycle among the plurality of OCV values measured for each cycle. Thereafter, the battery status diagnosing apparatus 1000 may obtain information on the specific cycle in which the corresponding OCV value was measured. For example, the predefined threshold value may be 0.0001V.

Thereafter, the battery status diagnosing apparatus 1000 may check the charge time in the next cycle with respect to the specific cycle (S3000). In other words, if the specific cycle is cycle N, the battery status diagnosing apparatus 1000 may check the charge time of the battery in cycle N+1.

Here, the charge time may include a first charge time and a second charge time. According to one embodiment, the first charge time may be time duration for charging the battery using a constant current (CC) charging method. According to another embodiment, the charge time may include a first charge time and a second charge time which is a time duration for charging the battery using a constant voltage (CV) charging method.

In other words, the battery status diagnosing apparatus 1000 may diagnose abnormal state of the battery by using at least one of the first charge time and the second charge time of the next cycle (N+1 Cycle) after the specific cycle (N Cycle) (S4000).

According to an embodiment, the battery status diagnosing apparatus 1000 may determine that an abnormality has occurred in the battery in the instance that the first charge time of the next cycle (cycle N+1) compared to that of the specific cycle (cycle N) increases by equal to or greater than a predefined first threshold or in the instance that the second charge time of the next cycle compared to that of the specific cycle decreases by equal to or greater than a predefined second threshold.

According to another embodiment, the battery status diagnosing apparatus 1000 may determine that an abnormality has occurred in the battery in the instance that the first charge time of the next cycle (cycle N+1) compared to that of the specific cycle (cycle N) increases by equal to or greater than a predefined first threshold and that the second charge time of the next cycle compared to that of the specific cycle decreases by equal to or greater than a predefined second threshold.

Here, the battery abnormality may be a gas eruption phenomenon that occurs before the battery ignites due to thermal runaway.

Accordingly, the battery status diagnosing apparatus 1000 may diagnose abnormal conditions of the battery that occur as preliminary signs before ignition occurs due to thermal runaway of the battery. Thus, the battery status diagnosing apparatus 1000 may provide a battery use environment with improved safety.

Thereafter, the battery status diagnosing apparatus 1000 may repeatedly perform steps S1000 to S4000 and count the number of times the abnormal condition has been diagnosed.

Thereafter, when the number of times (C) counting the abnormal state of the battery is equal to or more than K (S5000), the battery status diagnosing apparatus 1000 may output an alarm notifying a manager of a dangerous situation (S6000).

According to one embodiment, the battery status diagnosing apparatus 1000 may generate an alarm sound to inform the manager of a fire risk situation when the number of battery abnormalities is K or more.

According to another embodiment, the battery status diagnosing apparatus 1000 may transmit a warning message to an operator terminal when the number of abnormal battery states is K or more, thereby informing the manager of a fire risk situation.

However, the battery status diagnosing apparatus 1000 is not limited to what is described and may inform the manager of a fire risk situation using various methods such as vibration.

In the foregoing, the battery status diagnosing apparatus and method according to embodiments of the present invention has been described above. Hereinafter, the method of diagnosing the state of a battery will be described in more detail based on experimental examples of the present invention.

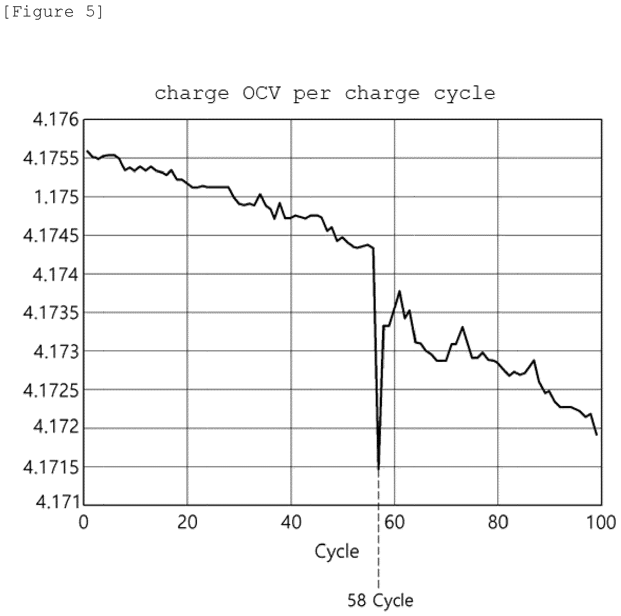

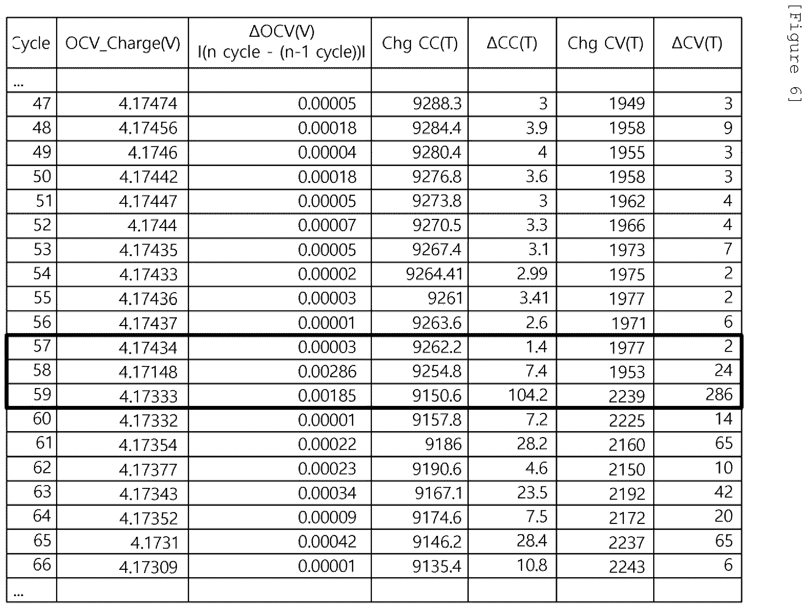

FIG. 5 is a graph showing OCV values measured for each charge cycle of the battery according to an experimental example of the present invention and FIG. 6 is a table summarizing the OCV values measured for each charge cycle of the battery according to FIG. 5.

Generally, the voltage value of the battery gradually decreases by a level within a preset threshold as the charge cycle progresses.

Meanwhile, if an abnormality occurs in the battery, the voltage value of the battery may rapidly decrease by a level greater than the preset threshold.

Accordingly, the battery status diagnosing apparatus 1000 may monitor whether an OCV value in a certain cycle has a change amount (△OCV) which is equal to or greater than a predefined threshold compared to the OCV value in the previous cycle among a plurality of OCV values (OCV_Charge) measured for each cycle.

Thereafter, if the OCV value in a certain cycle exceeds the threshold, the battery status diagnosing apparatus 1000 may check information on the specific cycle in which the corresponding OCV value was measured.

Referring to FIG. 5, it can be understood that the OCV value of the battery rapidly decreases at charge cycle of 58, and then rapidly recovers again at cycle 59.

In more detail with reference to FIG. 6, it can be understood that the OCV changes in other charge cycles are all less than 0.001V except for the OCV change between battery charge cycle 58 and battery charge cycle 59.

For example, with regard to the OCV change at cycle 57 which is right before cycle 58, the OCV value of the battery is 4.17437V at battery charge cycle of 56 and the OCV of the battery is 4.17434V in battery charge cycle of 57 and thus, the OCV change in cycle 57 is 0.00003V.

Meanwhile, the OCV value of the battery is measured as 4.17148Vin the battery charge cycle of 58, and thus, the OCV value at charge cycle 58 has dropped sharply by 0.00286V compared to the OCV value at cycle 57 (4.17434V).

In addition, the OCV value of the battery is measured as 4.17333V in battery charge cycle of 59, which can be understood that the OCV value in charge cycle of 59 has rapidly recovered by 0.00185V compared to the OCV value of cycle58(4.17148V).

Accordingly, the battery status diagnosing apparatus 1000 may predict that an abnormality has occurred in the battery at charge cycle 58 in which the OCV change exceeds a predefined threshold. Accordingly, the battery status diagnosing apparatus 1000 may define cycle 58 as information on the specific cycle in which an abnormality occurs. Here, the predefined threshold may be set by an operator based on the OCV changes measured for each charge cycle. For example, the threshold may be 0.0001V.

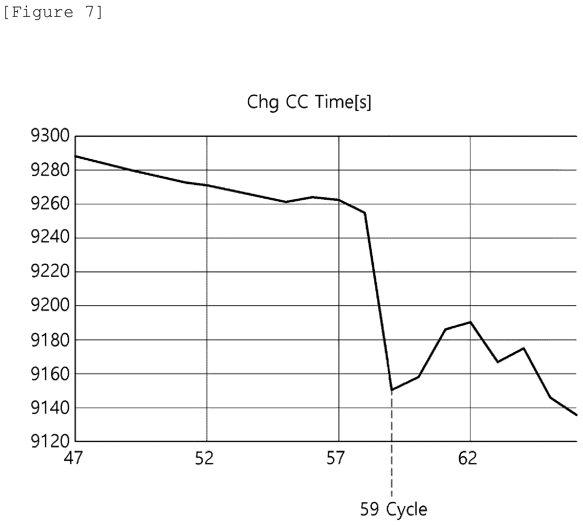

FIG. 7 is a graph showing a first charge time for each battery charge cycle in the battery status diagnosing method according to an experimental example of the present invention.

Referring to FIG. 7 shows that the first charge time (Chg CC) of the battery rapidly decreases in cycle 59, which is the next cycle of cycle 58 which was obtained using the information on the specific cycle in FIG. 5.

In more detail with reference to FIG. 7, it is shown that the first charge times (Chg CC) in other charge cycles all change within 30 seconds except for the first charge time (Chg CC) in cycle59.

Meanwhile, it is shown that the first charge time (Chg CC) in cycle 58 which is the specific cycle is 9254.8 seconds and the first charge time (Chg CC) in cycle 59, which is the next cycle, is shown as 9150.6 seconds. In other words, the first charge time (Chg CC) is shortened (△CC) by 104.2 seconds at cycle 59 compared to the previous cycle, which is cycle 58.

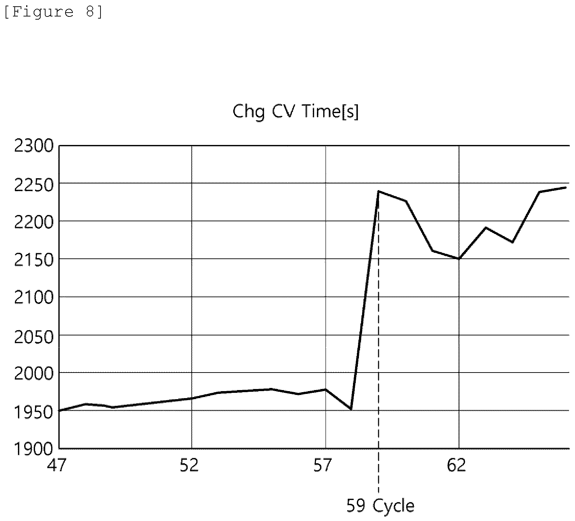

FIG. 8 is a graph showing the second charge time for each battery charge cycle in the battery status diagnosing method according to another experimental example of the present invention.

Referring to FIG. 8, it shows that the second charge time (Chg CV) of the battery rapidly increases in cycle 59, which is the next cycle of cycle 58 which was obtained with specific cycle information in FIG. 5.

In more detail with reference to FIG. 8, it shows that the second charge times (Chg CV) in other charge cycles all change within 70 seconds except for the second charge time in cycle59.

Meanwhile, it is shown that the second charge time (Chg CV) in cycle 58 which is the specific cycle is1953 seconds and the second charge time (Chg CV) in the next cycle, cycle 59, is shownas2239 seconds. In other words, the second charge time (Chg CV) has increased by 286 seconds (△CV) at cycle 59 compared to the previous cycle, cycle 58.

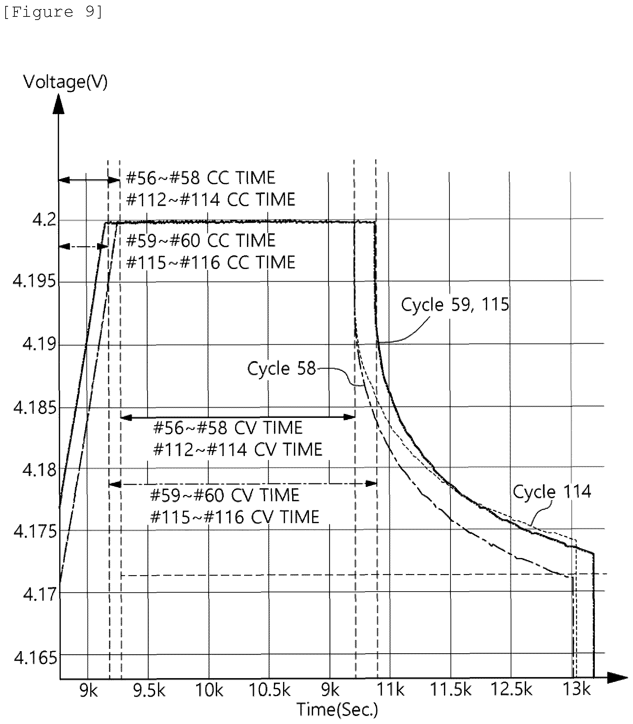

FIG. 9 is a graph showing size change of OCV according to charge time for each charge cycle of the battery according to an experimental example of the present invention.

Referring to FIG. 9, based on cycle 58 which is a specific cycle, the first charge time (CC Time) in cycle 59 which is the next cycle is decreased (as 9150.6 seconds) by more than a predefined first threshold value (for example, 100 seconds) compared to the first charge time in the specific cycle.

In addition, based on the specific cycle, cycle 58, the second charge time (CV Time) in the next cycle, cycle 59, increases (as 2239 seconds) by more than a predefined second threshold (e.g., 150 seconds), and gas venting occurred in the battery at this moment.

Therefore, the battery status diagnosing apparatus 1000 according to embodiments and experimental examples of the present invention may determine that an abnormality has occurred in the battery in the instance that changes of the first charge time (CC Time) and the second charge time (CV Time) in the next cycle with regard to the specific cycle exceed the first threshold value and second threshold value, respectively.

Meanwhile, it is shown that not only at cycle 58, but also when the charge cycle of the battery is cycle 114, the OCV value of the battery decreases sharply and recovers rapidly again at cycle 115. In other words, it is understood that cycle 114 is also a specific cycle.

Thereafter, as shown in FIG. 9, the first charge time is reduced by more than the first threshold and the second charge time is increased by more than the second threshold not only at the 59th cycle but also at the 115th cycle, and the battery had ignited afterwards.

Therefore, the battery status diagnosing apparatus 1000 according to the embodiments and experimental examples of the present invention may count a number of times the abnormal state of the battery has been diagnosed, as in steps S5000 to S6000 in FIG. 3, and send an alarm to the administrator when the counted number is equal to or greater than a predefined threshold, thereby ensuring safe battery use.

The battery status diagnosing apparatus and method according to the embodiments and experimental examples of the present invention have been described above.

The battery status diagnosing apparatus and method according to the embodiments and experimental examples of the present invention may monitor whether an abnormality in the voltage measurement value at a specific cycle occurs among charge cycles of the battery, diagnose an abnormal state of the battery based on the charge time in the next cycle after the specific cycle, and thus, ensure safe battery use.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include hardware devices specially configured to store and execute program instructions, such as ROM, RAM, flash memory, etc. The program instructions may include not only machine language code created by a compiler, but also highlevel language code that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery status diagnosing apparatus comprising:
at least one processor; and
a memory configured to store at least one instruction executed by the at least one processor,
wherein the at least one instruction includes:
an instruction to monitor whether an abnormality in voltage measurement values occurs in a specific cycle among a plurality of charge cycles of the battery;
an instruction to check charge time of the battery in the next cycle that proceeds after the specific cycle in which the abnormality occurs; and
an instruction to diagnose an abnormal status of the battery based on the charge time of the battery in the next cycle.

2. The battery status diagnosing apparatus of claim **1,** wherein the charge time includes:
a first charge time which is the duration it takes to charge the battery using a constant current (CC) charging method; and
a second charge time which is the duration it takes to charge the battery using a constant voltage (CV) charging method.

3. The battery status diagnosing apparatus of claim 1, wherein the instruction to diagnose an abnormal status of the battery includes an instruction to diagnose an abnormal status of the battery by comparing charge time of the specific cycle in which the abnormality occurs with the charge time of the next cycle.

4. The battery status diagnosing apparatus of claim 3, wherein the instruction to diagnose an abnormal status of the battery includes:
an instruction to determine that an abnormality has occurred in the battery in the instance that the constant current (CC) charge time of the next cycle compared to that of the specific cycle increases by equal to or greater than a predefined first threshold or in the instance that the constant voltage (CV) charge time of the next cycle compared to that of the specific cycle decreases by equal to or greater than a predefined second threshold.

5. The battery status diagnosing apparatus of claim 3, wherein the instruction to diagnose an abnormal status of the battery includes:
an instruction to determine that an abnormality has occurred in the battery in the instance that the constant current (CC) charge time of the next cycle compared to that of the specific cycle increases by equal to or greater than a predefined first threshold and that the constant voltage (CV) charge time of the next cycle compared to that of the specific cycle decreases by equal to or greater than a predefined second threshold.

6. The battery status diagnosing apparatus of claim 1, wherein the instruction to monitor whether an abnormality in voltage measurement values occurs in a specific cycle includes:
an instruction to obtain a plurality of open circuit voltage (OCV) measurement values measured for each charge cycle;
an instruction to monitor at least one OCV measurement value, among the plurality of OCV measurement values, that has a change amount greater than a predefined threshold compared to the OCV measurement value in the previous cycle; and
an instruction to determine the charge cycle in which at least one OCV measurement value with the change amount greater than a predefined threshold is detected as the specific cycle in which the abnormality occurs.

7. The battery status diagnosing apparatus of claim 1, wherein the abnormal status of the battery includes a status in which the battery is at risk of ignition or a status in which venting of the battery occurs.

8. The battery status diagnosing apparatus of claim 1, wherein the at least one instruction further includes:
an instruction to count the number of times the abnormal state of the battery has been diagnosed; and
an instruction to output an alarm when the counted number of abnormal status diagnosis is equal to or greater than a predefined threshold value.

9. A method for diagnosing battery status by a battery status diagnosis apparatus, the method comprising:
monitoring whether an abnormality in voltage measurement values occurs in a specific cycle among a plurality of charge cycles of the battery;
checking charge time of the battery in the next cycle that proceeds after the specific cycle in which the abnormality occurs; and
diagnosing an abnormal status of the battery based on the charge time of the battery in the next cycle.

10. The method of claim 9, wherein the charge time includes:
a first charge time which is the duration it takes to charge the battery using a constant current (CC) charging method; and
a second charge time which is the duration it takes to charge the battery using a constant voltage (CV) charging method.

11. The method of claim 9, wherein the diagnosing the abnormal status of the battery includes diagnosing an abnormal status of the battery by comparing charge time of the specific cycle in which the abnormality occurs with the charge time of the next cycle.

12. The method of claim 11, wherein the diagnosing the abnormal status of the battery includes determining that an abnormality has occurred in the battery,
in the instance that the constant current (CC) charge time of the next cycle compared to that of the specific cycle increases by equal to or greater than a predefined first threshold, or
in the instance that the constant voltage (CV) charge time of the next cycle compared to that of the specific cycle decreases by equal to or greater than a predefined second threshold.

13. The method of claim 11, wherein the diagnosing the abnormal status of the battery includes determining that an abnormality has occurred in the battery in the instance that the constant current (CC) charge time of the next cycle compared to that of the specific cycle increases by equal to or greater than a predefined first threshold, and that the constant voltage (CV) charge time of the next cycle compared to that of the specific cycle decreases by equal to or greater than a predefined second threshold.

14. The method of claim 9, wherein the monitoring whether an abnormality in voltage measurement values occurs in a specific cycle includes:
obtaining a plurality of open circuit voltage (OCV) measurement values measured for each charge cycle;
monitoring at least one OCV measurement value, among the plurality of OCV measurement values, that has a change amount greater than a predefined threshold compared to the OCV measurement value in the previous cycle; and
determining the charge cycle in which at least one OCV measurement value with the change amount greater than a predefined threshold is detected as the specific cycle in which the abnormality occurs.

15. The method of claim 9, wherein the abnormal status of the battery includes a status in which the battery is at risk of ignition or a status in which venting of the battery occurs.

16. The method of claim 9, further comprising:
counting the number of times the abnormal state of the battery has been diagnosed; and
outputting an alarm when the counted number of abnormal status diagnosis is greater than or equal to a predefined threshold value.
